# EUROPEAN PATENT APPLICATION

(11) **EP 2 103 719 A1**
(43) Date of publication of application: **23.09.2009**
(21) Application number: 08005041.2
(22) Date of filing: 18.03.2008
(51) Int. Cl.: C25D 13/02, C25D 13/18, C25D 13/22, C25D 15/00, C23C 24/08, B22F 7/00

(54) **A method for producing a multilayer structure**

(71) Applicant: Technical University of Denmark, 2800 Kgs. Lyngby (DK)
(72) Inventor: Menon, Mohan, 2640 Hedehusene (DK); Larsen, Peter Halvor, 4000 Roskilde (DK)
(74) Representative: Grünecker, Kinkeldey, Stockmair & Schwanhäusser Anwaltssozietät

(57) **Abstract**

Provided is method for producing a multilayer structure, one method comprising the steps of:
- providing a suspension comprising first particles and second particles, wherein the first and second particles have opposite charges;
- introducing an electrode and a counterelectrode into the suspension;
- applying a current to said electrode and counterelectrode, whereby at least one layer comprising said first particles is deposited on said electrode and at least one layer comprising said second particles is deposited on the counterelectrode; and
- changing the direction of the current applied to said electrode and said counterelectrode, whereby at least one layer comprising said second particles is deposited on the electrode and at least one layer comprising said first particles is deposited on the counterelectrode.

In another embodiment, there is provided a method for producing a multilayer structure, comprising the steps of:
- providing a suspension comprising first particles and particles having magnetic properties, wherein the first particles are charged;
- introducing an electrode having electromagnetic properties and a counterelectrode into the suspension;
- applying current to said electromagnetic electrode and counterelectrode, whereby at least one layer comprising said first particles is deposited on said electrode; and
- applying an electromagnetic field to said electrode, whereby at least one layer comprising said particles having magnetic properties is deposited on said electrode.

The present invention also provides multilayer structures obtainable by said processes.

## Description

### Field of the invention

The present invention relates to methods for producing a multilayer structure or multi-layer coating, and to a multilayer structure obtainable by said methods.

### Background art

Ceramic multilayer structures are generally employed in applications such as microelectronic devices, transducers, membranes, and thermally insulating coatings. Especially in the field of membranes, ceramic multilayer structures are commonly used in form of microstructures sandwiched between current collector layers.

Depending on the desired application of the multilayer structure, the number of required ceramic layers forming the membrane may vary. If, for example, a membrane for flue gas cleaning is desired, an application of growing importance in view of today's desire to protect the global environment, a large number of ceramic layers of the multilayer structure forming part of the membrane is required.

Emission of soot particles (particulate material, PM) and NOx from combustion engines are the cause of substantial environmental as well as health problems especially in larger cities where the air due to intensive traffic contains large quantities of PM and NOx. Both types of emission are severely damaging to human health and can for instance cause lung cancer.

US-A-5,401,372 discloses an electrochemical catalytic reduction cell for the reduction of NOx in an O₂-containing exhaust emission using a gas-diffusion catalyst, such as supported vanadium oxides, with an electron collecting layer, such as a conductive perovs-kite-type oxide, e.g. LSM.

US-A-5,456,807 relates to a method and apparatus for selectively removing nitrogen oxides from gaseous mixtures comprising the absorption of NOx with NOx absorbents, heating release of absorbed NOx, and electrochemical reduction of NOx to N₂ and O₂ in solid oxide cells.

Common methods for producing ceramic multilayer structures being suitable as membranes include tape casting, slip casting, and screen printing processes. An alternative method is electrophoretic deposition (EPD). EPD is a facile colloidal method for fabrication of ceramic monoliths, composites, laminates, and functionally graded materials. Advantageously, the so formed laminates exhibit a strongly bonded interface. EPD has also been used to deposit inorganic coatings on fine wires for valve filaments and cathodes, or to deposit wax on metals.

In EPD, charged powder particles are deposited from a suspension onto the surface of an electrode of opposite charge via application of a current. By repeating the deposition step using different powder particle materials in different suspensions, layered ceramic structures can be built up. The rate of deposition is for instance controllable via the applied potential and can be very fast.

The above described deposition of different layers is generally carried out by using multiple suspensions, each comprising one specific material to be deposited. By exchanging the various suspensions from which the particles are deposited, a multilayer structure comprising layers from different materials may be sequentially formed on the respective electrode.

In order to homogeneously suspend the powders to be deposited on the electrode, often polymers, such as polyelectrolytes, are employed. Typical solvents for the suspensions are water, ethanol and acetylacetone. The polymers further provide the necessary charge for the EPD progress, for example by comprising functional groups.

However, in case a multilayer structure with a large number of layers, such as 10 layers or more, is required, the employed suspensions have to be exchanged repeatedly, resulting in a labour intensive process and in return in a slowing down of the manufacture process. Also, the deposited surfaces must be subjected to cleaning steps in between, such as rinsing with water or alcohol, before being brought in contact with the next suspension, in order to avoid the contamination of the suspensions over time.

### Object of the present invention

In view of the above described shortcomings of the prior art, it was the object of the present invention to provide new methods for producing a ceramic multilayer structure, with which multilayer structures can be produced in an easy and work efficient way, and with which multilayer structures having any number of ceramic layers can be obtained in a short amount of time.

### Brief description of the invention

The above object is achieved by a method for producing a multilayer structure, comprising the steps of:
- providing a suspension comprising first particles and second particles, wherein the first and second particles have opposite charges;
- introducing an electrode and a counterelectrode into the suspension;
- applying a current to said electrode and counterelectrode, whereby at least one layer comprising said first particles is deposited on said electrode and at least one layer comprising said second particles is deposited on the counterelectrode; and
- changing the direction of the current applied to said electrode and said counterelectrode, whereby at least one layer comprising said second particles is deposited on the electrode and at least one layer comprising said first particles is deposited on the counterelectrode.

The above object is further achieved by a method for producing a multilayer structure, comprising the steps of:
- providing a suspension comprising first particles and particles having magnetic properties, wherein the first particles are charged;
- introducing an electrode having electromagnetic properties and a counterelectrode into the suspension;
- applying a current to said electrode having electromagnetic properties and counterelectrode, whereby at least one layer comprising said first particles is deposited on said electrode; and
- applying an magnetic field to said electrode having electromagnetic properties, whereby at least one layer comprising said particles having magnetic properties is deposited on said electrode.

This object is moreover achieved by a method for producing a multilayer structure, comprising the steps of:
- providing a suspension comprising first particles;
- providing a second suspension comprising second particles;
- introducing a means for depositing a layer of first particles into the first suspension, wherein the pressure inside said means is adjustable to a pressure which is lower than the pressure outside the means;
- depositing at least one layer of said first particles on said means;
- introducing said means into the second suspension, and
- depositing at least one layer of said second particles on top of said layer of first particles.

This object is furthermore achieved by a method for producing a multilayer structure, comprising the steps of:
- providing a suspension comprising first particles;
- providing a second suspension comprising second particles;
- depositing at least one layer of said first particles on a support by introducing the support into the suspension of the first particles;
- drying said at least one layer;
- depositing at least one layer of said second particles on top of said layer of first particles by introducing the support into the suspension of the second particles.

This object is finally achieved by a multilayer structure, obtainable by any of said methods.

Preferred embodiments are set forth in the subclaims and the following detailed description.

### Brief description of the drawings

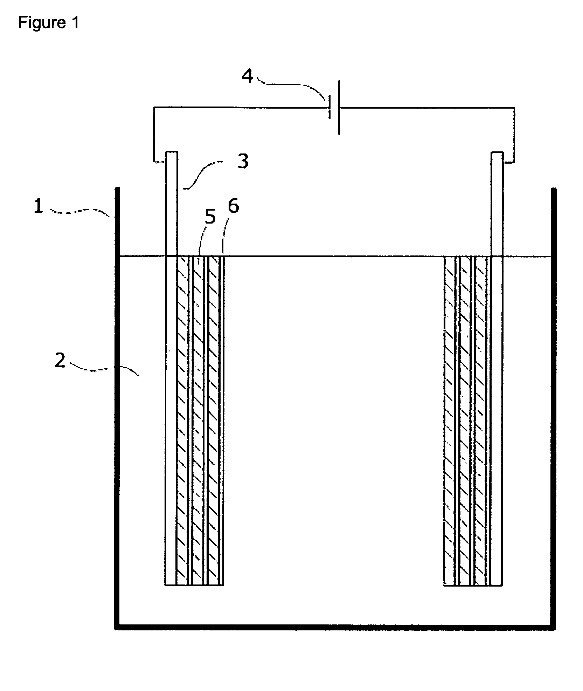

Figure 1 illustrates a setup for the manufacture of a multilayer structure in accordance with the present invention comprising a reactor tank (1), a suspension with charged particles (2), and an electrode (3), on which layers (5, 6) are deposited; (4) depicts the electrical field. In case of magnetic deposition, the electrode (3) also has electro magnetic properties.

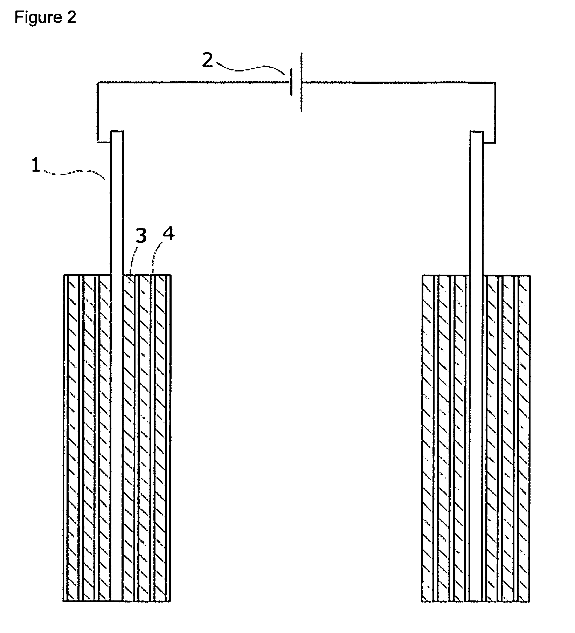

Figure 2 illustrates another setup in accordance with the present invention for the manufacture of a double sided or cylindrical multilayer structure. The setup includes an electrode (1), on which layers (3, 4) are deposited; (2) depicts the electrical field.

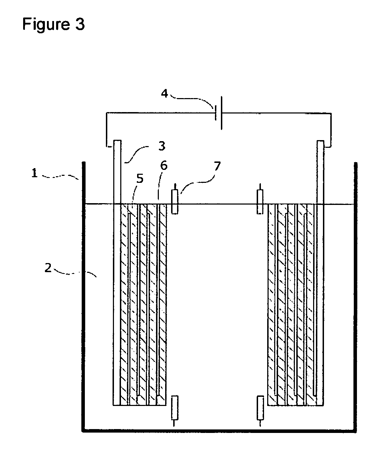

Figure 3 illustrates another setup for the manufacture of a multilayer structure in accordance with the present invention comprising a reactor tank (1), a suspension with charged particles (2), and an electrode (3), on which layers (5, 6) are deposited; (4) depicts the electrical field, (7) indicates blocking sheets.

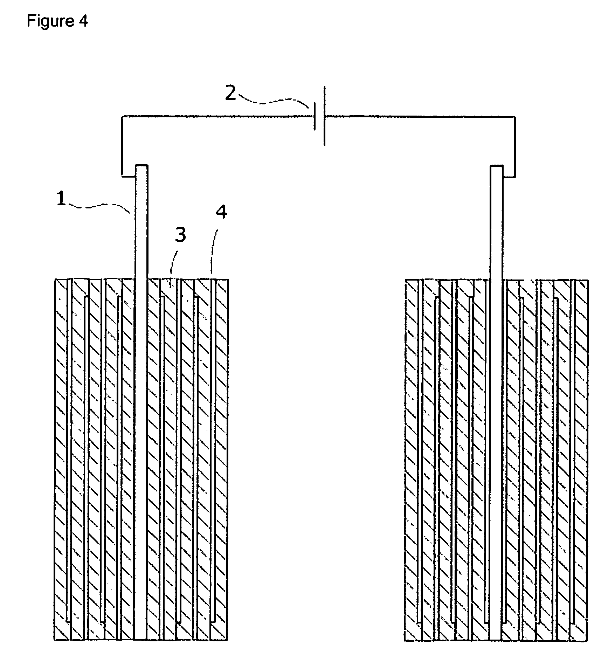

Figure 4 illustrates a setup for a double sided deposition in accordance with the present invention. The setup includes an electrode (1), on which layers (3, 4) are deposited; (2) depicts the electrical field.

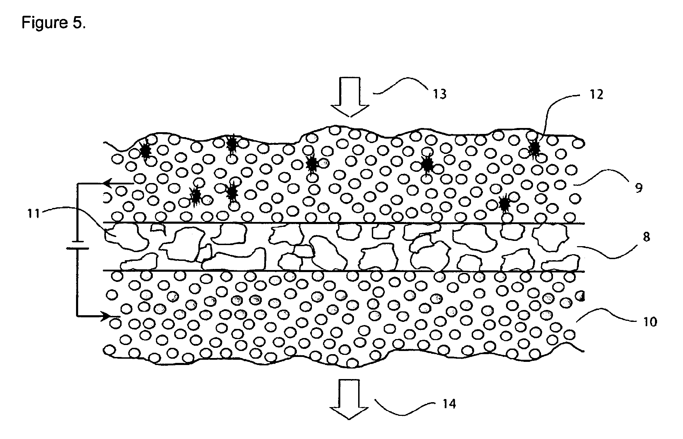

Figure 5 illustrates the principle of a flue gas cleaning cell that allow for removal of both soot and NOx in one reactor.

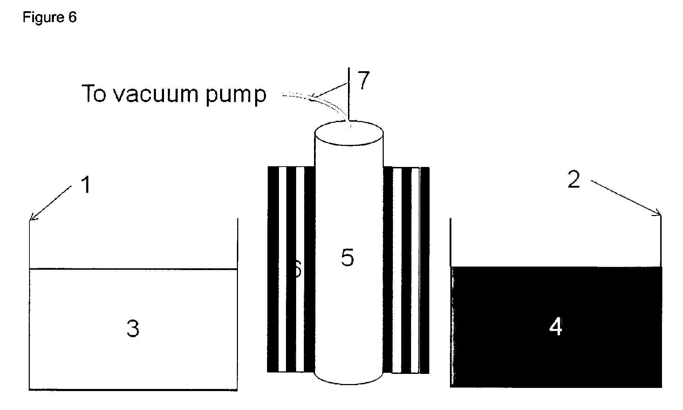

Figure 6 illustrates another setup for the manufacture of a multilayer structure in accordance with the present invention comprising two reactor tanks (1 and 2) with two suspensions (3 and 4), a tube (5) onto which layers (6) are deposited by creating low pressure inside the tube using a pump connected by a hose (7).

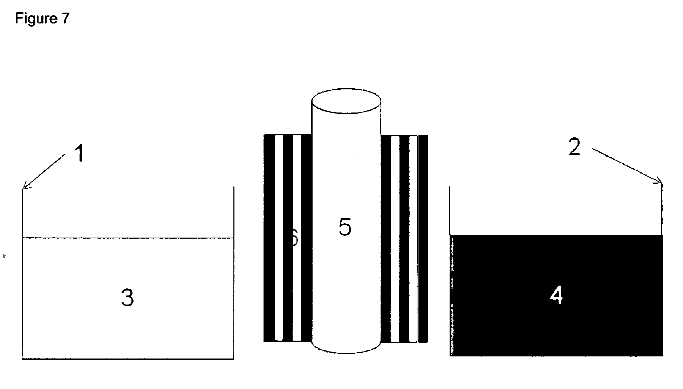

Figure 7 illustrates another setup for the manufacture of a multilayer structure in accordance with the present invention comprising two reactor tanks (1 and 2) with two suspensions (3 and 4), a tube (5) onto which layers (6) are deposited by introducing the tube into suspensions (3 and 4).

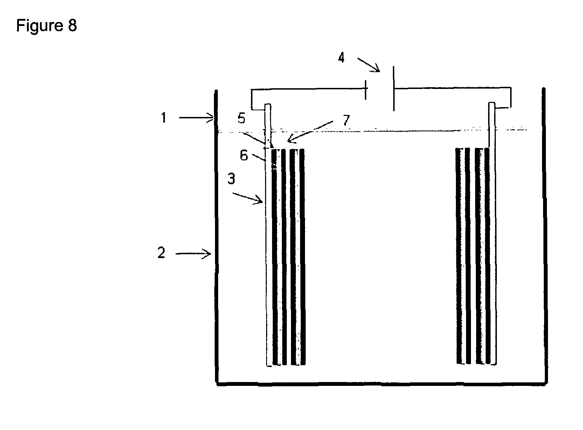

Figure 8 illustrates another setup for the manufacture of a multilayer structure in accordance with the present invention comprising a reactor tank (1), a suspension with charged particles (2), and an electrode (3), on which layers (5, 6) are deposited. A graphite mesh (7) is applied to the deposited layers and further layers (5, 6) are deposited; (4) depicts the electrical field.

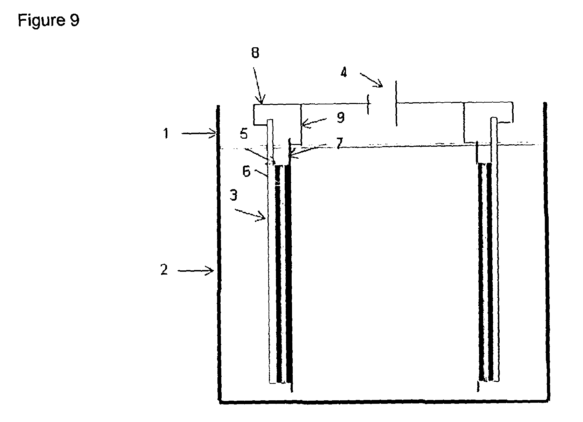

Figure 9 illustrates another setup for manufacture of a multilayer structure in accordance with the present invention comprising a reactor tank (1), a suspension with charged particles (2), and an electrode (3), on which layers (5, 6) are deposited. A graphite mesh (7) is applied to the deposited layers and further layers are deposited; (4) depicts the electrical field. The graphite mesh (7) is connected to the field by wires (9).

### Detailed description of the invention

The present invention provides a method for producing a multilayer structure, comprising the steps of:
- providing a suspension comprising first particles and second particles, wherein the first and second particles have opposite charges;
- introducing an electrode and a counterelectrode into the suspension;
- applying a current to said electrode and counterelectrode, whereby at least one layer comprising said first particles is deposited on said electrode and at least one layer comprising said second particles is deposited on the counterelectrode; and
- changing the direction of the current applied to said electrode and said counterelectrode, whereby at least one layer comprising said second particles is deposited on the electrode and at least one layer comprising said first particles is deposited on the counterelectrode.

In the first step of the method of the present invention, a suspension comprising first particles and second particles is provided. The first particles and second particles have opposite charges. Advantageously, due to the provision of only one suspension comprising both, the first and second particles at the same time, there is no need to change the suspension each time a new layer of particles is to be deposited on the respective electrode. This results in a time efficient process and a simplified apparatus. Moreover, less labour is required during each of the manufacturing processes.

In the second step, an electrode and a counterelectrode are introduced into the suspension. The electrode and counterelectrode are then externally connected to a power supply for applying an electrical field.

Afterwards, a current, i.e. DC, is applied to said electrode and counterelectrode so as to deposit at least one layer comprising said first particles on said electrode and at least one layer comprising said second particles on the counterelectrode simultaneously, i.e. the positively charged particles are deposited on the negative electrode and the negatively charged particles are deposited simultaneously on the positive electrode.

Preferably, the voltage applied is from 5 to 500 V, more preferably from 10 to 200 V, and most preferably from 15 to 50 V.

After the deposition of the respective layers on the electrode and counterelectrode, the direction of the current applied to said electrode and said counterelectrode is changed. The positive electrode thus becomes the negative electrode and vice versa. Due to alternating the direction of the current, a layer comprising the second particles is deposited on top of the already formed layer of first particles on the electrode, while a layer comprising first particles is deposited on the already formed layer of second particles on the counterelectrode.

Since the suspension already comprises the first and second particles, there is no need to exchange the suspension prior to depositing the next layer of particles on the respective electrodes. Thus, the method does not need to be interrupted in order to exchange the suspensions, and cleaning steps in order to avoid contamination of the suspensions are omitted. The method is consequently less labour and time intensive while allowing for a deposition of in principle any number of layers to be deposited.

By repeatedly alternating the direction of the current, a multilayer structure comprising layers formed of first and second particles is formed on the electrode and counterelectrode. Advantageously, any desired number of layers can be deposited while using only one suspension, which can be fine-tuned depending on the desired application of the multi-layer structure.

In another embodiment of the present invention, there is provided a method for producing a multilayer structure, comprising the steps of:
- providing a suspension comprising first particles;
- providing a second suspension comprising second particles;
- depositing at least one layer of said first particles on a support by introducing the support into the suspension of the first particles;
- drying said at least one layer;
- depositing at least one layer of said second particles on top of said layer of first particles by introducing the support into the suspension of the second particles.

In yet another embodiment, the electrode is an electrode connected to a power supply and having magnetic properties. The electrode having electromagnetic properties includes electrodes which may, for example, be formed from an electromagnetic material, electrodes which include material having electromagnetic properties but is not solely formed thereof, and electrodes in which the core or the outer parts may be formed from an electromagnetic material. Preferably, also the counterelectrode is an electrode having electromagnetic properties. In the first step of the method of this embodiment of the present invention, a suspension comprising first particles and particles having magnetic properties is provided. Again, advantageously, due to the provision of only one suspension comprising both, the first particles and the particles having magnetic properties at the same time, there is no need to change the suspension each time a new layer of particles is to be deposited on the respective electrode. This results in a time efficient process and a simplified apparatus required to carry out the method of the present invention. Moreover, less labour is required during each of the manufacturing processes.

In the second step, an electrode and a counterelectrode are introduced into the suspension. The electrode and counterelectrode are then externally connected to a power supply for applying an electrical field.

Afterwards, a current is applied to said electrode and counterelectrode so as to deposit at least one layer comprising said first particles on said electrode.

After the deposition of the respective layers on the electrode, the electromagnetic field at the electrode is switched on. At least one layer comprising the particles having magnetic properties is deposited on top of the already formed layer of first particles on the electrode.

In a preferred embodiment, the suspension comprising first particles and particles having magnetic properties further comprises second particles, wherein the first and second particles have opposite charges. Thus, not only layers of the first particles and the particles having magnetic properties can be deposited on the respective electrode, but additionally layers comprising second particles can be deposited as well. Preferably, both the said electrode and counterelectrode have electromagnetic properties. This allows for a greater variety of different layers being deposited from the same suspension without the need to interrupt the process for exchange of suspensions or cleaning steps.

In another preferred embodiment, the method further comprises the step of changing the direction of the current applied to said electrode and to said counterelectrode, whereby at least one layer comprising said second particles is deposited on the electrode and at least one layer comprising said first particles is deposited on the counterelectrode. The direction of the current can be changed as outlined above, and of course the order of layers can be chosen depending on the desired later application. Therefore, not only layers of first and second particles can be deposited, but also layers comprising the particles having magnetic properties as well.

In another preferred embodiment, the step of applying a current to said electrode is carried out simultaneously with applying an electromagnetic field to said electrode, whereby a layer comprising said first particles and said particles having magnetic properties are co-deposited on the electrode. This allows for depositing a layer comprising a mixture of first particles and particles having magnetic properties. If also second particles having a charge being opposite to the charge of the first particles are present, of course also layers comprising a mixture of second particles and particles having magnetic properties can be deposited.

In a more preferred embodiment, the current applied to the electrode is maintained and the magnetic field is applied using the electromagnet attached to the electrode simultaneously for short periods of time. In this case, first particles are deposited throughout the process, and layers comprising first particles alternate with layers comprising first particles and particles having magnetic properties. Of course, this allows for alternating the current if second particles are present in the suspension as well.

The setup is preferably a setup for double deposition at the electrode and counter electrode at the same time. Therefore, the counterelectrode is preferably a counterelectrode also having electromagnetic properties, like the electrode.

In another preferred embodiment, a graphite layer, such as a graphite mesh (7) is applied to the deposited layers and further layers (5, 6) are deposited, as illustrated in Figures 8 and 9. During sintering, electric current may be passed through the graphite mesh, resulting in resistive heating from within the multilayered structure, which advantageously ensures a better temperature distribution. Depending on the number of layers, of course more than one graphite mesh may be used if desired.

In a more preferred embodiment, the graphite mesh (7) is applied to the deposited layers and is connected to the DC power supply (4) by wires (9), as illustrated in Figure 9. The electrode (3) is then disconnected from the power supply (4) by removing wires (8). Further layers are deposited on top of the graphite mesh (7). The resistance of the electrode increases with increasing number of layers deposited on the electrode which, in turn, decreases the deposition rate. When the graphite mesh (7) is advantageously connected to the power supply, it acts as an electrode and the deposition rate for subsequent depositions can be maintained at the same level as for the first layers, making the process more efficient.

In another embodiment, the present invention also provides a method for producing a multilayer structure, comprising the steps of:
- providing a suspension comprising first particles;
- providing a second suspension comprising second particles;
- introducing a means for depositing a layer of first particles into the first suspension, wherein the pressure inside said means is adjustable to a pressure which is lower than the pressure outside the means;
- depositing at least one layer of said first particles on said means;
- introducing said means into the second suspension, and
- depositing at least one layer of said second particles on top of said layer of first particles.

In this method, two different suspensions comprising first and second particles are obtained. Unlike the above described methods, said suspensions are not combined. In this method, instead of using a solid electrode, a means is employed which is adjustable to a pressure which is lower than the pressure outside the means. Thus, a pressure being lower than the pressure of the suspension surrounding the means can be applied inside the means, forcing the particles of the respective suspensions to be sucked onto the means and form a layer. By exchanging the suspensions or by moving and introducing the means into the different suspensions, different layers can be deposited on the means. Of course, more than two suspensions may be employed if more than two different suspensions are provided.

By controlling the pressure inside said means, the number of layers advantageously can be as high as desired. After some layers have been deposited, the pressure can be further reduced to maintain a steady deposition of the respective particles. The applied initial pressure is preferably less than 8 x 10⁵ Pa, more preferably less than 5 x 10⁵ Pa.

Advantageously, in this embodiment, there is no need to employ an electrode, or an electrode having electromagnetic properties, thereby simplifying the process to some extend.

However, the above method is not limited to only the described means for depositing a layer of first particles into the first suspension, wherein the pressure inside said means is adjustable to a pressure which is lower than the pressure outside the means. In a more preferred embodiment, the means is a porous electrode, thereby combining the advantages of the above embodiments. Layers comprising charged particles can be deposited as described above well as layers comprising neutral or non magnetic particles, allowing for even further freedom in depositing different layers. The suspension comprising first particles may comprise second particles, and/or particles having magnetic properties, and/or particles which may be deposited by the above described means being adjustable to a pressure which is lower than the pressure outside the means.

Preferably, the number of layers deposited with any of the above methods is at least 5. More preferred is the number of layers deposited being at least 20, with the number of layers of at least 50 being most preferred.

The thickness of each deposited layer is dependent from various parameters, such as the applied current, the frequency by which the field is alternated, the strength of the applied electrical field, the distance between the electrodes, and the time the electrical field is applied to the suspension. Furthermore, the suspension properties, such as the viscosity and solids loading, also influence the thickness of the deposited layers. How to properly select the respective parameters for obtaining the desired thickness is well known to a person skilled in the art.

Preferably, the thickness of each deposited layer in the multilayer structure of the present invention is from 0.5 to 40 µm, more preferably from 1 to 20 µm and even more preferably from 2 to 10 µm. Of course, the thickness can be below or above said values if desired, depending on the intended application of the multi-layer structure.

Any material suitable for EPD can be employed for the electrode and counterelectrode, as is well known to the skilled person. Preferred electrode materials include metal electrodes, such as platinum, palladium, nickel, copper, stainless steel, graphite, carbon and conductive polymers etc. Electrodes made from semiconductors may also be employed. Furthermore, additional layers may be deposited by attaching the said layer on electrode materials listed above.

Advantageously, the electrode has the specific shape desired for the later multilayer to be formed thereon, and is designed such that the release of the multilayer is facilitated. Any shape can be used as long as the layers can be deposited thereon, and the invention is not limited to round or flat shaped or rod-like electrodes. The electrodes may further have any form of desired pattern thereon, depending on the intended use of the multilayer structure.

The first and second particles are preferably selected from but not limited to the group consisting of doped cerium oxide or doped zirconium oxide, doped lanthanum manganate, doped lanthanum iron cobaltite, Al₂O₃, ZrO₂, TiO₂, SiO₂, doped titanates, Si₃N₄, BN and monazite.

Opposite charges of the first particles and second particles are preferably obtained by adsorption of a polyelectrolyte on the surface of at least one of said first and second particles. More preferred is that both, the first and the second particles, are provided with opposite charges by adsorption of a polyelectrolyte on the surface thereof. Positively charged particles are preferably provided by employing poly(ethyleneimine) (PEI). Negatively charged particles are preferably obtained by using an acrylic copolymer with carboxylic groups, Darvan C, which is an ammonium polymethacrylate, or by using EH2A20, EH2A35 or EH2A55, which are copolymers of ammonium acrylate and hydroxyethyl acrylate.

Alternatively, opposite charges are obtained by manipulating the pH of the suspension. Any acid or base can be used to adjust the pH. Suitable acids include inorganic acids, such as HCl, HNO₃, H₂SO₄, and organic acids, such as acetic acid. Suitable bases include inorganic bases, such as alkali hydroxides, earth alkali hydroxides, ammonia and organic bases, such as alkali acetates and amines.

Suitable particles having magnetic properties include LSM, iron-, cobalt- or manganese oxides and mixtures thereof.

In one preferred embodiment, the suspension is obtained by separately suspending the first and second particles in the respective solvents, charging the particles with opposite charges, followed by mixing the separate suspensions so as to obtain the final suspension comprising the first and second particles in which the electrode and counterelectrode are introduced.

As suitable solvents for the suspension, water, alcohols, such as ethanol, propanol, isopropanol, buthanol, amyl alcohol, acetone, and acetylacetone, or mixtures thereof, may be used. Preferred is however water, ethanol, or a mixture thereof.

Preferably, the electrical field is in the range of from 5 to 500 V/cm, more preferably from 10 to 200 V/cm, and even more preferred from 15 to 50 V/cm. The current densities preferably range of from 0.001 to 1 mA/cm², more preferably of from 0.01 to 0.2 mA/cm².

In a further preferred embodiment the above described methods comprise the additional steps of:
- sintering the multilayer structure deposited on the electrode; and
- impregnating the outermost layers with a catalyst material or catalyst precursor material.

The sintering temperature is generally between 700°C and 1600°C, depending on the selected materials for the respective layers.

After the impregnation with a catalyst material or catalyst precursor material has been completed, preferably current collectors are applied to the outermost layers.

In case of flue gas cleaning, it is preferred to use alkali metal or alkali earth metal oxides as NO getter materials.

In another embodiment, the present invention provides a method for producing a multi-layer structure, comprising the steps of:
- providing a suspension comprising first particles;
- providing a second suspension comprising second particles;
- depositing at least one layer of said first particles on a support by introducing the support into the suspension of the first particles;
- drying said at least one layer;
- depositing at least one layer of said second particles on top of said layer of first particles by introducing the support into the suspension of the second particles.

In this method, at least two different suspensions comprising first and second particles are obtained. However, said suspensions are not combined. In this method, instead of using a electrode having electric and, optionally, electromagnetic properties, a support is employed which is introduced into the respective suspensions. Said support may have any desired form and may be shaped as desired for the later multilayer structure deposited thereon. By exchanging the suspensions or by introducing the support into different suspensions, different layers can be deposited on the support. Of course, more than two suspensions may be employed if more than two different suspensions are provided.

Advantageously, in this embodiment, there is no need to employ an electrode, or an electrode having electromagnetic properties, thereby simplifying the process to a large extend. Additionally, no pressure control means is required, further reducing the operating demands of the method and apparatus.

The present invention also provides a multilayer structure, obtainable by any of the above methods. Advantageously, the multilayer structure can have any desired number of layers. The thickness of each layer can be fine-tuned separately, depending from the desired application. Of course, since the electrode or means on which the layers are deposited can be shaped accordingly, the multi-layer structure is not limited to flat structures but can be shaped as desired as long as deposition of the respective layers is possible.

The multilayer structure obtainable with the method of the present invention may be used in applications such as electrical devices, structural/mechanical devices which require a high mechanical strength, as a membrane component for flue gas cleaning, for piezo-ceramic multilayer components (actuators, sensors, transducers etc.), for multi-layer transformers, multilayer capacitors, and for structural multilayer components having a controlled fracture mode.

The multilayer structures are especially suitable for use in flue gas cleaning applications. Figure 5 illustrates the principle of a flue gas cleaning cell that allow for removal of both soot and NOx in one reactor. The reactor comprises a symmetrical construction having an oxide ion conducting electrolyte 8 sandwiched between two electrodes 9, 10. In the configuration shown in Figure 5, all the layers are porous, and the flue gas passes across the structure. On the cathode side 10, NO is reduced by electrons (e⁻) to N₂ gas and oxide ions (O⁻). The oxide ions are transported through the electrolyte material 11 to the anode side 9 where they react with the soot particles (C, 12) and form CO₂ and electrons. By alternating the voltage across the reactor, the electrodes will shift from anode to cathode thus removing PM or NO, respectively. The gas flow 13 enters the structure, and the gas flow 14 exits the structure in Figure 5.

The multilayer structure can be designed to have a high mechanical strength, for example by the layers being formed from Al₂O₃/ZrO₂. The multilayer structure may also have a controlled fracture mode/structure, for example when the layers are formed from combinations of Monazite/Al₂O₃.

In the following, the invention will be illustrated by examples. Alternative embodiments and examples exist without departing from the scope of the present invention.

### Examples

### Example 1: Manufacture of a flue gas purifier

### - Step 1: Preparation of a suspension comprising negatively charged particles

Ce_{0.1}Gd_{0.9}O_{1.95} (CGO) powders were added to an ethanol - water (75 - 25 wt%) mixture. 0.1 wt% (CGO basis) of Darvan C was added to the mixture. Subsequently, the suspension was ball milled and the zeta potential, particle size distribution (PSD) and viscosity were controlled.

### - Step 2: Preparation of a suspension comprising positively charged particles

La₁₋ₓSrₓMnO₃ (LSM) powders were added to an ethanol - water (75 - 25 wt %) mixture. 0.1 wt% (LSM basis) of PEI was added to the mixture. Subsequently, the suspension was ball milled and the zeta potential, PSD and viscosity were controlled.

### - Step 3: Mixing of the suspensions and EPD

Two conducting polymer sheets separated by 2 cm were introduced into a container as the electrode and counter-electrode. The suspension obtained in step 2 was then poured into the container. The electrode was connected to the positive terminal and the counter-electrode to the negative terminal of a DC powder supply and 40 volts were applied for 3 min. This resulted in deposition of LSM on the counter-electrode. The suspension from step 1 was then added to the container and the connections to the power supply were swapped and 40 volts were applied for 3 min.. The swapping of the connections to the powder supply and the deposition were repeated 30 times. After the 30^{th} deposition, the electrode was removed for drying from the container and replaced with another conducting polymer sheet. The electrode was then connected to the positive terminal and the counter-electrode to the negative terminal of the power supply and 40 volts were applied for 3 min., resulting in a coating of LSM on the counter-electrode. The counter-electrode was then removed from the container and dried. The suspensions were stirred throughout the deposition process.

### - Step 4: Sintering and impregnation

The layered body obtained in step 3 was sintered at 1200°C for 2h. The porous layered body was subsequently impregnated two times with a saturated solution of Ba(NO₃)₂.

Figure 1 illustrates a setup for the manufacture of a electrochemical flue gas purifier as used in this example. In Figure 1, the setup comprises a reactor tank (1), a suspension with charged particles (2), an electrode (3), on which LSM (5) and the electrolyte CGO (6) is deposited in layers. (4) depictures the electrical field.

### Example 2: Manufacture of a layered composite

### - Step 1: Preparation of a suspension comprising negatively charged particles

Al₂O₃ powders were added to an ethanol - water (75 - 25 wt %) mixture. 0.1 wt% (Al₂O₃ basis) of Darvan C was added to the mixture. Subsequently, the suspension was ball milled and the zeta potential, particle size distribution (PSD) and viscosity were controlled.

### - Step 2: Preparation of a suspension comprising positively charged particles

3 mol% Y₂O₃ stabilized ZrO₂ (TZP) powders were added to an ethanol - water (75 - 25 wt %) mixture. 0.1 wt% (TZP basis) of PEI was added to the mixture. Subsequently, the suspension was ball milled and the zeta potential, PSD and viscosity were controlled.

### - Step 3: Mixing of the suspensions and EPD

The suspensions obtained in steps 1 and 2 were mixed in a container. Two sheets of graphite were introduced as the electrode and the counter-electrode into the container, separated by 2 cm. The electrodes were connected to a DC powder supply and 60 volts were applied for 1 min. Then the connections to the power supply were swapped and 60 volts were applied for 1 min. This procedure was repeated 10 times.

### - Step 4: Sintering

The layered body obtained in step 3 was sintered at 1600°C for 2h, and a layered composite was obtained.

### Example 3: Manufacture of a multilayer actuator

### - Step 1: Preparation of a suspension comprising negatively charged particles

PZT powders, Pb(Zr_{0.52}Ti_{0.48})O₃, were added to an ethanol - water (75 - 25 wt %) mixture. 0.1 wt% (PZT basis) of Darvan C was added to the mixture. Subsequently, the suspension was ball milled and the zeta potential, particle size distribution (PSD) and viscosity were controlled.

### - Step 2: Addition of metal ions to the suspension and EPD

Silver nitrate was dissolved in the suspension, resulting in Ag⁺ ions in the suspension, and the resulting suspension was poured into a container. Two sheets of graphite were introduced as electrode and counter-electrode into the container separated by 5 cm. The electrode was connected to the positive and counter-electrode to the negative terminal of a DC powder supply and 50 volts were applied for 1 min. The electrode was then taken out and replaced by another graphite sheet. Then the connections to the power supply were swapped and 50 volts were applied for 1 min. This procedure of swapping the connections and application of field was repeated 15 times. The counter-electrode was then removed from the container for drying, and replaced with another graphite sheet. The connections to the powder supply were swapped (electrode connected to the negative terminal) and 50 volts applied for 1 min. When an electrode had negative polarity (to attract Ag⁺), a thin metal sheet covers the top and bottom of the electrode (with 1 mm distance between the electrode and the cover), in order to prevent deposition of metal at the edges as indicated in Figure 3.

In Figure 4, the electrodes are illustrated as electrodes on which the deposition of the layers occurs on both sides. In Figure 4, also the deposition of metal at the edges was prevented. This setup was used in this example.

### - Step 3: Sintering

The layered body obtained in step 2 was sintered at 900°C for 2h to obtain a multilayer actuator.

### - Step 4: Application of outer electrodes

After sintering a silver electrode was applied to both ends of the actuator shown in Figure 4.

### Example 4: Manufacture of a flue gas purifier using magnetic deposition

### - Step 1: Preparation of negatively charged suspension

Ce_{0.1}Gd_{0.9}O_{1.95} (CGO) powders were added to an ethanol - water (75 - 25 wt %) mixture. 0.1 wt% (CGO basis) of Darvan C was added to the mixture. Subsequently, the suspension was ball milled and the zeta potential, particle size distribution (PSD) and viscosity were controlled.

### - Step 2: Preparation of neutral LSM suspension

La₁₋ₓSrₓMnO₃ (LSM) powders were added to an ethanol - water (75 - 25 wt %) mixture. 10 wt% (LSM basis) of PVP was added to the mixture. Subsequently, the suspension was ball milled and the zeta potential, PSD and viscosity were controlled.

### - Step 3: Mixing of the suspensions and EPD

Two sheets of a polymer conducting materials with one rolled around an electromagnet were introduced as electrode (rolled around the electromagnet) and counter-electrode into a container, separated by 2 cm. The electrode and the counter-electrode were connected to the positive and negative terminals of a DC power supply respectively.

The suspensions from step 1 and 2 were mixed together in this container. The electromagnet present in the positive electrode was turned on for 1 min, resulting in formation of LSM layer on the positive electrode. 40 volts were then applied to the electrodes using the DC power supply for 1 min, resulting in formation of CGO layer on the LSM layer. Deposition occurred in this case only on the positive electrode. This procedure was repeated for 21 times.

The electrical field was shut off when the magnetic field was on and vice-versa.

### - Step 4: Sintering and impregnation

The layered body obtained in step 3 was sintered at 1200°C for 2h. The porous layered body was subsequently impregnated two times with a saturated solution of Ba(NO₃)₂.

### Example 5: Manufacture of a flue gas purifier using magnetic deposition

### - Step 1: Preparation of negatively charged suspension

A CGO suspension was prepared following step 1 from example 4.

### - Step 2: Preparation of neutral LSM suspension

A LSM suspension was prepared following step 2 from example 4.

### - Step 3: Mixing of the suspensions and EPD

The EPD was performed following step 3 from example 4. LSM layer number 1, 11 and 21 were deposited for 30 seconds. Graphite grids were then placed on these LSM layers such that 5 mms of LSM layers were exposed at the left and right edges (see Figure 8). On the top and bottom of the LSM layer, the grid protruded by 5 mm. Subsequently, LSM layer was deposited on top of the grids for another 30 seconds.

### - Step 4: Sintering and impregnation

A current was passed through the graphite grids embedded in the layered body from step 3, resulting in heating of the body. The layered body obtained in step 3 was sintered at 1200C for 2h. The porous layered body was subsequently impregnated with a saturated solution of Ba(NO₃)₂.

### Example 6: Manufacture of a flue gas purifier using magnetic deposition

### - Step 1: Preparation of a negatively charged suspension

A CGO suspension was prepared following step 1 from example 4.

### - Step 2: Preparation of a neutral LSM suspension

A LSM suspension was prepared following step 2 from example 4.

### - Step 3: Mixing of the suspensions and EPD

The EPD was performed following step 3 from example 4. The deposition of LSM and CGO layers was repeated 51 and 50 times respectively, resulting in a body with 101 layers. In order to maintain required electric field for the deposition of CGO, fine graphite mesh was placed on the 25^{th} layer (12^{th} LSM layer) covering the whole LSM area and protruded out of the suspension on the top. More LSM was deposited onto the graphite mesh. The graphite mesh was connected to the positive terminal of the DC power supply and was used for deposition of the CGO layers. This setup is illustrated in Figure 9.

### - Step 4: Sintering and impregnation

The layered body obtained in step 3 was sintered at 1200°C for 2h. The porous layered body was subsequently impregnated a number of times with a saturated solution of Ca(NO₃)₂.

### Example 7: Manufacture of a flue gas purifier using magnetic deposition

### - Step 1: Preparation of a negatively charged suspension

A CGO suspension was prepared following step 1 from example 4.

### - Step 2: Preparation of a neutral LSM suspension

A LSM suspension was prepared following step 2 from example 4.

### - Step 3: Mixing of the suspensions and EPD

The suspensions from step 1 and 2 were mixed and deposition was performed following step 3 from Example 4.

### - Step 4: Sintering and impregnation

The layered body obtained from step 3 was sintered in a microwave oven operating at 2,45 GHz at a temperature of 1000°C for 2 minutes. The porous layered body was subsequently impregnated two times with a saturated solution of Ba(NO₃)₂.

### Example 8: Manufacture of a flue gas purifier using magnetic deposition

### - Step 1: Preparation of a negatively charged suspension

CGO suspensions were prepared following step 1 from example 4.

### - Step 2: Preparation of a neutral LSM suspension

A LSM suspension was prepared following step 2 from example 4.

### - Step 3: Mixing of the suspensions and EPD

Two sheets of graphite were introduced as electrode and counter-electrode into a container, separated by 2cm. The electrode and the counter-electrode were connected to the positive and negative terminals of a DC power supply respectively. An electromagnet was placed behind the positive electrode.

Suspensions from step 1 and 2 were mixed together in this container. The electromagnet was turned on for 1 min. At the same time, 30 volts were applied to the electrodes for 1 min. This resulted in the formation of a composite LSM - CGO layer on the positive electrode. The electromagnet was then turned off and 40 volts were applied to the electrodes using the DC power supply for 1 min, resulting in formation of CGO layer on the CGO - LSM layer. This procedure was repeated for 21 times.

### - Step 4: Sintering and impregnation

The layered body obtained in step 3 was sintered at 1200°C for 2h.

### Example 9: Manufacture of a flue gas purifier using magnetic deposition

### - Step 1: Preparation of a negatively charged suspension

A CGO suspension was prepared following step 1 from example 4.

### - Step 2: Preparation of a neutral LSM suspension

A LSM suspension was prepared following step 2 from example 4.

### - Step 3: Mixing of the suspensions and EPD

Two hollow sheets of graphite were introduced as electrode and counter-electrode into a container, separated by 2 cm. The electrode and the counter-electrode were connected to the positive and negative terminals of a DC power supply respectively. An electromagnet was placed in the positive electrode.

The suspension from step 1 was poured into the container. The electromagnet was turned on for 5 seconds and 5ml of LSM suspension from step 2 was poured into the container. The electromagnet was then shut off and 40 volts were applied to the electrodes using the DC power supply for 1 min, resulting in formation of CGO layer on the LSM layer. This procedure was repeated for 21 times.

### - Step 4: Sintering and impregnation

The layered body obtained in step 3 was sintered at 1200°C for 2h.

### Example 10: Manufacture of a flue gas purifier using magnetic deposition

### - Step 1: Preparation of a negatively charged suspension

A CGO suspension was prepared following step 1 from example 4.

### - Step 2: Preparation of a neutral LSM suspension

A LSM suspension was prepared following step 2 from example 4.

### - Step 3: Mixing of the suspensions and EPD

Two hollow sheets of graphite were introduced as electrode and counter-electrode into a container, separated by 2cm. The electrode and the counter-electrode were connected to the positive and negative terminals of a DC power supply respectively. An electromagnet was placed in the positive electrode.

The suspension from step 1 was poured into the container. The electromagnet was then turned on for 5 seconds and 5ml of LSM suspension from step 2 was poured into the container. The electromagnet was then shut off and 60 volts were applied to the electrodes using the DC power supply for 1 min, resulting in formation of CGO layer on the LSM layer. This procedure was repeated for 21 times.

### - Step 4: Sintering and impregnation

The layered body obtained in step 3 was sintered at 1200°C for 2h. The porous layered body was subsequently impregnated five times with a saturated solution of Ba(NO₃)₂.

### Example 11: Manufacture of a flue gas purifier using differential pressure deposition

### - Step 1: Preparation of CGO and LSM suspensions

A CGO suspension was prepared following step 2 from example 4 using CGO powders instead of LSM. A LSM suspension was prepared following step 2 from example 4.

### - Step 2: Deposition

The LSM and CGO suspensions were poured into two separate containers. One end of a porous MgO tube (30% porous) was attached to a vacuum pump and the other sealed prior to introducing it into the LSM suspension. A vacuum is pulled inside the tube (a pressure of 6·10⁵ Pa) causing the LSM to deposit on the surface of the tube. After 2 minutes, the vacuum is turned off and the tube is removed from the LSM suspension and introduced into the CGO suspension. Vacuum is turned on causing CGO film to form on the LSM film. This process is repeated 29 times (LSM suspension being the last suspension the tube is dipped in). This process is illustrated in Figure 6

### - Step 3: Sintering and impregnation

The layered body obtained in step 2 was sintered at 1200°C for 2h. The porous layered body was subsequently impregnated five times with a saturated solution of Ba(NO₃)₂.

### Example 12: Manufacture of a flue gas purifier using dip coating

### - Step 1: Preparation of CGO and LSM suspensions

A CGO suspension was prepared following step 2 from example 4 using CGO powders instead of LSM. A LSM suspension was prepared following step 2 from example 4.

### - Step 2: Deposition

A porous MgO tube (porosity of 30%) closed at one end, was used as a substrate. The tube was introduced into the LSM suspension (prepared in step 1) and withdrawn at a speed of 0.5 mm/sec, resulting in a thin CGO layer on the LSM tape. This tape was then introduced into the CGO suspension from step 1, and withdrawn at a speed of 2 mm/sec. This process was repeated 25 times with LSM being the last layer deposited. This process is illustrated in Figure 7.

### - Step 3: Sintering and impregnation

The layered body obtained in step 2 was sintered at 1200°C for 2h. The porous layered body was subsequently impregnated five times with a saturated solution of Ba(NO₃)₂.

## Claims

1. A method for producing a multilayer structure, comprising the steps of:
- providing a suspension comprising first particles and second particles, wherein the first and second particles have opposite charges;
- introducing an electrode and a counterelectrode into the suspension;
- applying a current to said electrode and counterelectrode, whereby at least one layer comprising said first particles is deposited on said electrode and at least one layer comprising said second particles is deposited on the counterelectrode; and
- changing the direction of the current applied to said electrode and said counterelectrode, whereby at least one layer comprising said second particles is deposited on the electrode and at least one layer comprising said first particles is deposited on the counterelectrode.

2. A method for producing a multilayer structure, comprising the steps of:
- providing a suspension comprising first particles and particles having magnetic properties, wherein the first particles are charged;
- introducing an electrode having electromagnetic properties and a counterelectrode into the suspension;
- applying a current to said electrode having electromagnetic properties and counterelectrode, whereby at least one layer comprising said first particles is deposited on said electrode; and
- applying an magnetic field to said electrode having electromagnetic properties, whereby at least one layer comprising said particles having magnetic properties is deposited on said electrode.

3. The method of claim 2, wherein the suspension comprising first particles and particles having magnetic properties further comprises second particles, and wherein the first and second particles have opposite charges.

4. The method of claim 3, wherein the method further comprises the step of alternating the electrical field applied to said electrode and to said counterelectrode, whereby at least one layer comprising said second particles is deposited on the electrode and at least one layer comprising said first particles is deposited on the counterelectrode.

5. The method of any of claims 1, 3 and 4, wherein the opposite charge of the first and second particles is obtained by adsorption of a polyelectrolyte on the surface thereof.

6. The method of any of claims 1, 3 and 4, wherein said suspension is obtained by separately suspending the first and second particles and charging the particles with opposite charges, followed by mixing the separate suspensions.

7. The method of any of claims 2 to 6, wherein the step of applying a current to said electrode is carried out simultaneously with applying an electromagnetic field to said electrode, whereby a layer comprising said first particles and said particles having magnetic properties are co-deposited on the electrode.

8. A method for producing a multilayer structure, comprising the steps of:
- providing a suspension comprising first particles;
- providing a second suspension comprising second particles;
- introducing a means for depositing a layer of first particles into the first suspension, wherein the pressure inside said means is adjustable to a pressure which is lower than the pressure outside the means;
- depositing at least one layer of said first particles on said means;
- introducing said means into the second suspension, and
- depositing at least one layer of said second particles on top of said layer of first particles.

9. A method for producing a multilayer structure, comprising the steps of:
- providing a suspension comprising first particles;
- providing a second suspension comprising second particles;
- depositing at least one layer of said first particles on a support by introducing the support into the suspension of the first particles;
- drying said at least one layer;
- depositing at least one layer of said second particles on top of said layer of first particles by introducing the support into the suspension of the second particles.

10. The method of any of claims 1 to 9, wherein the number of layers deposited on the electrode is at least 5.

11. The method of any of claims 1 to 9, wherein the number of layers deposited on the electrode is at least 20.

12. The method of any of claims 1 to 11, wherein the thickness of each deposited layer is from 0,5 to 40 µm.

13. The method of any of claims 1 to 12, wherein the first particles and the second particles are selected from the group consisting of doped cerium oxide, doped lanthanum manganite, doped lanthanum ferrocobaltite, Al₂O₃, ZrO₂, TiO₂, SiO₂, doped titanates, Si₃N₄, BN and monazite.

14. The method of any of claims 1 to 13, further comprising the steps of:
- sintering the multilayer structure deposited on the electrode; and
- impregnating the outermost layers of the multilayer structure with a catalyst material or catalyst precursor material.

15. The method of claim 14, further comprising the step of applying current collectors to the outermost layers after impregnation.

16. The method of claim 14, wherein a NOx getter material is alkali metal oxide or alkali earth metal oxide.

17. A multilayer structure, obtainable by the method of any of claims 1 to 16.

18. Use of the multilayer structure of claim 17 for flue gas cleaning, or for piezo-ceramic multilayer components, or for multilayer transformers, or for multilayer capacitors, or for multilayer components having a high mechanical strength, or for multilayer components having a controlled fracture mode/structure, or for electrical devices, or for a structural/mechanical device.
